Europäisches Patentamt

European Patent Office

Office européen des brevets

(19)

(11) Publication number: **0 004 285**

**B1**

(12) **EUROPEAN PATENT SPECIFICATION**

(45) Date of publication of patent specification: **11.08.82**

(21) Application number: **79100510.1**

(22) Date of filing: **21.02.79**

(51) Int. Cl.³: **H 01 L 21/31,**
**H 01 L 21/306,**
**C 23 C 15/00**

(54) **A method of plasma etching silica at a faster rate than silicon in an article comprising both.**

(30) Priority: **21.03.78 US 888882**

(43) Date of publication of application:
**03.10.79 Bulletin 79/20**

(45) Publication of the grant of the patent:
**11.08.82 Bulletin 82/32**

(84) Designated Contracting States:
**DE FR GB**

(56) References cited:
**US - A - 3 806 365·**

**JAPANESE JOURNAL OF APPLIED PHYSICS,**
**vol. 16, no. 1, 1977 Tokyo S.MATSUO et al.**
**"Preferential SiO2 Etching on Si Substrate by**
**Plasma Reactive Sputter Etching", pages 175—**
**176.**
**SOLID-STATE ELECTRONICS, vol. 18, no. 12,**
**December 1975, Oxford R.A. HEINECKE,**
**"Control of Relative Etch Rates of SiO2 and Si in**
**Plasma Etching", pages 1146—1147.**

(73) Proprietor: **International Business Machines**
**Corporation**
**Armonk, N.Y. 10504 (US)**

(72) Inventor: **Coburn, John Wyllie**
**6122 Franciscan Way**
**San Jose California 95120 (US)**
Inventor: **Winters, Harold Franklin**
**632 Lanfair Drive**
**San Jose California 95136 (US)**

(74) Representative: **Richards, John Peter**
**IBM UNITED KINGDOM PATENT OPERATIONS**
**Hursley Park**
**Winchester Hants, SO21 2JN (GB)**

Courier Press, Leamington Spa, England.

A method of plasma etching silica at a faster rate than silicon in an article comprising both

This invention relates to plasma etching.

Plasma etching has been recently evaluated for semiconductor processing since it promises a number of advantages over wet chemical methods in terms of improved yield and resolution at lower cost. Specifically, plasma etching is used to form a window through silica $(SiO_2)$ films on silicon (Si) substrates. In this type of etching it is desirable for the etchant to have a high etch rate in respect of $SiO_2$ relative to the etch rate of Si substrates. Furthermore, it is desirable to be able to adjust the $SiO_2/Si$ etch rate ratio in a convenient manner for different manufacturing applications.

Conventionally in the use of plasma etching for semiconductor manufacture, the primary gas in which the plasma etching glow discharge is established is a saturated halocarbon, typically $CF_4$. However, the use of this gas alone provides an etch rate of Si which is higher than that of $SiO_2$, the opposite of the desired result, and according to one technique developed by the industry it has become the practice to introduce into the plasma chamber a further gas which mixes with the $CF_4$ and is effective to decrease the fluorine/carbon (F/C) ratio of the active species in the discharge which participate in the etching process. This suppresses the etching of the Si to a greater or lesser extent, depending upon the nature of the further gas which is used and the relative proportions of the two gases in the mixture, so that preferential etching of the $SiO_2$ occurs.

Hydrogen is proposed as the further gas in US Patent 3,940,506, and in the article in Solid State Electronics, 1975, Vol. 18 at pages 1146—1147. The article however merely refers to a reduction in the Si etch rate but gives no values, and US Patent 3,940,506 discloses a maximum $SiO_2/Si$ etch rate ratio of 5:1, whereas a desirable ratio would be 10:1 to 20:1 or higher. There is no indication in either of these documents that a high $SiO_2/Si$ etch rate ratio can be attained through the use of hydrogen, nor the adjustability of the etch rate ratio over a wide range.

IBM TDB, Vol. 20, No. 2, July 1977, page 757 proposes the use of water vapour as the further gas mentioned above. However, this document only shows a maximum $SiO_2/Si$ etch ratio of about 4:1. Furthermore, the range of etch rate ratios which may be obtained is restricted (1:1 to 4:1).

Ethylene, ammonia, a mixture of oxygen and a noble gas (US Patent 4,028,155), and various other gases have also been proposed at various times as the further gas to be used in combination with $CF_4$ to reduce the Si etch rate relative to the $SiO_2$ etch rate. However, these gases do not provide results significantly different from those discussed above—certainly they do not readily provide a high etch rate ratio and the adjustability of the ratio over a wide range.

A second technique which has been used to decrease the F/C ratio in the $CF_4$ plasma is to use a solid surface (target) in the discharge region which is formed of a material which serves as a scavenger of F atoms, see IBM TDB, Vol. 19, No. 10, March 1977, page 3854. One such material, Teflon (Registered Trade Mark), is proposed in the Japanese Journal of Applied Physics, Vol. 16, 1977, No. 1, pages 175 and 176. In this case the reduction of the F/C ratio is stated to be accomplished by two mechanisms—by absorption of F by the Teflon target itself, and by $C_nF_{2n}$ gas released from the target. However, as in the case of the first-mentioned technique, the $SiO_2/Si$ etch ratios attained are quite modest both as regards magnitude and variation (approximately 5:1 to 7:1). Furthermore, this modest result is achieved by changing the pressure of the gas atmosphere which is not suitable for commercial use because of the lack of control over the F/C ratio—i.e. it is difficult to control the etch rate of the electrode material independently, and the etch rate of this material determines the extent to which the F/C ratio is adjusted.

There is, therefore, a clear need in the semiconductor manufacturing industry for a plasma etching technique which can provide a high $SiO_2/Si$ etch rate ratio and adjustability of the ratio over a wide range. In particular there is a need for an improvement in the technique of the kind first mentioned above consisting of the controlled introduction of a further gas into the plasma chamber to mix with the principle saturated halocarbon gas of the plasma discharge, in view of the ready control afforded by this technique.

Accordingly, the invention provides a method of plasma etching silica at a faster rate than silicon in an article comprising both silica and silicon, the method being of the kind which comprises placing the article in a plasma etching chamber, introducing a saturated halocarbon gas at an adjustable flow rate into the chamber, introducing a further gas at an adjustable flow rate into the chamber which is effective to reduce the halogen/carbon ratio of the gas mixture, adjusting the relative flow rates of the two gases to provide a desired silica/silicon etch rate ratio, and forming a plasma in the gas to etch the article, the method being characterised in that the further gas is an unsaturated halocarbon.

The advantage of the invention, compared to the prior art discussed above, is that it enables one to obtain an extremely high $SiO_2/Si$ etch rate ratio, up to infinity, and an adjustability of the ratio from infinity down to quite small or even fractional values.

**0 004 285**

These results are quite unpredictable on the basis of the art known to the applicants. The discovery that the use of an unsaturated halocarbon, of all the various gases which have been or could be used for the purpose, provides such dramatic results provides a very versatile technique and a valuable contribution to the art. Indeed, the only prior document of which we are aware which mentions unsaturated halocarbons in the context of plasma etching would indicate that the unsaturated halocarbons would not provide, in a method of the kind with which the present invention is concerned, results better than those already attained by other gases.

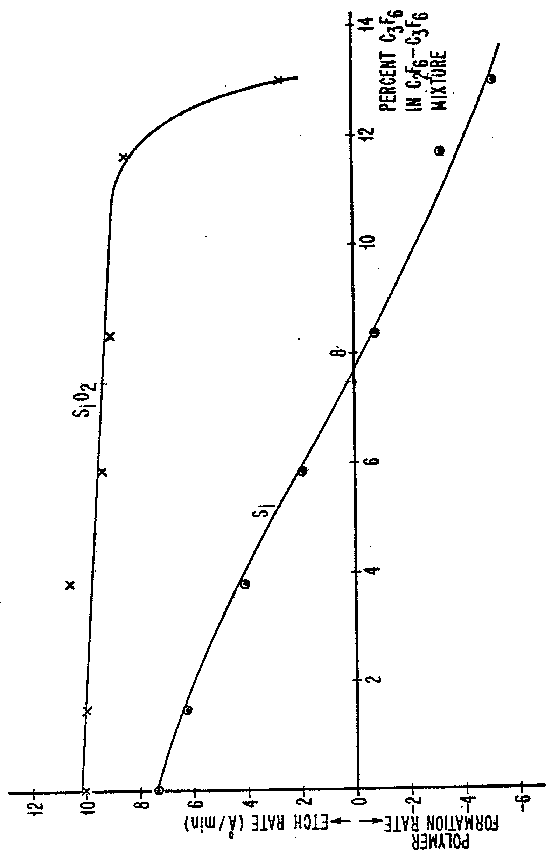

Thus, as stated above, the article in the Japanese Journal of Applied Physics, Vol. 16, shows in Fig. 1 that the combined absorptive effect of both the Teflon target and the released $C_nF_{2n}$ gas (an unsaturated halocarbon) provides only modest results. It is not, therefore, to be expected that one could use only an unsaturated halocarbon gas for the absorption and obtain better etch rate ratios or a wider variation thereof—indeed one would expect to obtain less good results if no Teflon target were present. The same article shows that the admixture of ethylene provides better results (up to 10:1 $SiO_2$/Si etch rate ratio) so that the article in fact points to the hydrocarbons as more likely candidates.

In summary, therefore, the invention provides a valuable and versatile technique for plasma etching in the semiconductor industry, and provides results which could not be predicted upon the basis of the very modest results attained by the single prior document which refers to the presence of an unsaturated halocarbon in a technique other than of the kind with which the present invention is concerned.

Embodiments of the invention will now be described with reference to Figure 1 which illustrates the relative etch rates of $SiO_2$ and Si in a $C_3F_6$—$C_2F_6$ mixture.

An apparatus suitable for performing the etching process consists essentially of four items; a bell jar system, a gas train for leaking gases or mixtures of gases at an adjustable rate into the bell jar, an RF generator for sustaining a plasma within the bell jar, and a vacuum pump. Any conventional plasma generating system may be employed and the electrode may be either within the system or a coil surrounding the outside of the system. The excitation power is delivered by an r.f. generator that capacitively applies the power to the plasma. A power of 50 to 150 watts, that is between 1/2 and 1 1/2 watts per square centimeter is an example thereof. The frequency of the applied voltages is of the order of 13.56 MHz. Direct current may also be used. Both the power and the frequency can be varied over broad ranges as is well known to those skilled in the art.

The plasma etching is effected by passing a mixture of gases through the etching chamber. The mixture of gases includes an unsaturated halocarbon and a saturated halocarbon. While both the saturated and unsaturated halocarbon may contain fluorine, bromine and/or iodine, the preferred gaseous components contain fluorine or mixtures of fluorine with another halide. In other words, the unsaturated halocarbon may contain only one halogen or it may contain a mixture of two or more halogens, for example, $C_3F_6$, $C_3F_4Cl_2$, $C_3F_2Cl_2Br_2$, and so forth. Similarly, the saturated halocarbon may contain only one halogen or a mixture of two or more halogens, for example, $CF_4$, $CF_3Cl$, $CF_2ClBr$, and so forth. Specific examples of preferred unsaturated halocarbons are $C_3F_6$ and $C_2F_4$. Examples of preferred saturated halocarbons are $CF_4$ and $C_2F_6$.

Preferably the gaseous mixture contains a single unsaturated halocarbon and a single saturated halocarbon. While it is possible to use more than two gases, the halogen/carbon ratio is easier to adjust in a two component system, however, more than two gases may be used if desired. The preferred halogen/carbon ratio needs to be determined experimentally for each particular system in order to find the preferred range since it may depend on the apparatus used. In the applicants' apparatus with unsaturated halocarbons containing fluorine, the preferred halogen/carbon ratio is between 2 and 3.

Example I

In a plasma etching system in which the total pressure was 2.66 pascals (20 millitorr), the unsaturated gas $C_3F_6$ was mixed with the saturated gas $C_2F_6$ to provide a flow rate of about 2.6 cm³/min. The generator delivered 13.5 MHz rf power which resulted in a 100 watts being applied. The excitation electrode area was 185 cm². The data set forth below show a comparison between the etch rate of $SiO_2$ and Si in Å/minute as the percentage by volume of the unsaturated component $C_3F_6$ is increased in the gaseous mixture. The etch rate with 0% $C_3F_6$ was 7.3 for Si and 10.0 for $SiO_2$. At a concentration of 5.9% $C_3F_6$ the etch rate of Si had gone down to 2.0 whereas the etch rate of $SiO_2$ was 9.3. For percentages of 8.4 to 13.0, the Si had a negative etch rate, that is, a polymer formation occurred on the wafer. The data are illustrated in Fig. 1 which clearly show the faster etch rate of $SiO_2$ over Si for the concentration range set forth.

| Percentage by Volume of $C_3F_6$ in $C_2F_6$—$C_3F_6$ Mixture | Si Etch Rate+ ($Å/min$) | $SiO_2$ Etch Rate+ ($Å/min$) |
|---|---|---|
| 0 | 7.3 | 10.0 |
| 1.5 | 6.3 | 10.0 |
| 3.8 | 4.1 | 10.6 |
| 5.9 | 2.0 | 9.3 |
| 8.4 | −0.7* | 9.0 |
| 11.7 | −3.2* | 8.5 |
| 13.0 | −5.1* | 2.7 |

+ — Etch rate measured on grounded wafers.
* — A negative etch rate means polymer formation.

A number of different combinations of unsaturated halocarbon and saturated halocarbon may be used in the etchings of Si wafers.

Example 2

A mixture of $C_3F_6$ and $CF_4$ was made under a total pressure of 2.66 pascals. The gas flow rate was 1.6 $cm^3/min$. A power of 50 watts was applied at 13.5 MHz. The $SiO_2$ excitation electrode area was 185 $cm^2$. The following tabulation set forth the data obtained.

| Percentage by Volume of $C_3F_6$ in $CF_4$—$C_3F_6$ Mixture | Si Etch Rate+ ($Å/min$) | $SiO_2$ Etch Rate+ ($Å/min$) |
|---|---|---|
| 0 | 16.9 | 11.7 |
| 5.3 | 14.1 | 11.3 |
| 10.5 | 10.9 | 11.0 |
| 15.8 | 7.2 | 10.1 |
| 20.9 | 2.1 | 8.5 |
| 26.2 | −1.3* | 4.1 |
| 32.0 | −2.0* | −3.0* |

+ — Etch rate measured on grounded wafers.
* — A negative etch rate means polymer formation.

In this system a gaseous mixture containing 20.9% $C_3F_6$ had an $SiO_2$ etch rate of 8.5 compared to a Si etch rate of 2.1.

Example 3

A mixture of $C_2F_4$ and $CF_4$ having a total gas flow rate of 1.3 $cm^3/min$ was used. The total pressure in the vacuum system was about 2.66 pascals. A 100 watts of power was applied at 13.56 MHz. The $SiO_2$ excitation electrode area was 100 $cm^2$. The following tabulation sets forth the data obtained. The etch rate of $SiO_2$ was 21.5 and the silicon etch rate of 0.5 occurred when 45.8% $C_2F_4$ was used in the mixture.

| Percentage by Volume of $C_2F_4$ in $CF_4$—$C_2F_4$ Mixture | Si Etch Rate+ ($Å/min$) | $SiO_2$ Etch Rate+ ($Å/min$) |
|---|---|---|
| 0 | 63.5 | 46.3 |
| 9.2 | 68.5 | 44.2 |
| 19.9 | 21.2 | 43.0 |
| 29.1 | 3.2 | 35.2 |
| 37.3 | 7.5 | 29.5 |
| 45.8 | 0.5 | 21.5 |
| 53.6 | −0.7* | −2.4* |
| 61.8 | −42.5* | −35.9* |
| 69.5 | −118.0* | −41.6* |

+ — Etch rate measured on grounded wafers.
* — Negative etch rate means polymer formation.

Claims

1. A method of plasma etching silica at a faster rate than silicon in an article comprising both silica and silicon, the method being of the kind which comprises placing the article in a plasma etching chamber, introducing a saturated halocarbon gas at an adjustable flow rate into the chamber, introducing a further gas at an adjustable flow rate into the chamber which is effective to reduce the halogen/carbon ratio of the gas mixture, adjusting the relative flow rates of the two gases to provide a desired silica/silicon etch rate ratio, and forming a plasma in the gas to etch the article, the method being characterised in that the further gas is an unsaturated halocarbon.

2. A method as claimed in claim 1, wherein the unsaturated halocarbon is $C_3F_6$.

3. A method as claimed in claim 1, wherein the unsaturated halocarbon is $C_2F_4$.

4. A method as claimed in claim 1, wherein the gaseous mixture contains $C_3F_6$ and $CF_4$.

5. A method as claimed in claim 1, wherein both the unsaturated and saturated halocarbons contain fluorine and the halogen/carbon ratio of the gaseous mixture is between 2 and 3.

Revendications

1. Procédé permettant de décaper au plasma, à une vitesse plus rapide, la silice que le silicium, tous les deux étant contenus dans un même article, le procédé étant du genre qui comprend les étapes suivantes: le placement de l'article dans une chambre de décapage au plasma, l'introduction d'un gaz halocarboné saturé avec un débit réglable dans la chambre, l'introduction d'un autre gaz avec un débit réglable dans la chambre qui permet de réduire le rapport halogène/carbone du mélange gazeux, le réglage des débits relatifs des deux gaz pour assurer un rapport désiré des vitesses de décapage silice/silicium et la formation d'un plasma dans le gaz pour décaper l'article, le procédé étant caractérisé en ce que ledit autre gaz est du type halocarboné non saturé.

2. Procédé selon la revendication 1 dans lequel l'halocarboné non saturé est du $C_3F_6$.

3. Procédé selon la revendication 1 dans lequel l'halocarboné non saturé est du $C_2F_4$.

4. Procédé selon la revendication 1 dans lequel le mélange gazeux contient du $C_3F_6$ et du $CF_4$.

5. Procédé selon la revendication 1 dans lequel les halocarbonés non saturés et saturés contiennent de fluor et dans lequel le rapport halogène/carbone du mélange gazeux est compris entre 2 et 3.

**Patentansprüche**

1. Verfahren zum Plasmaätzen eines Gegenstandes, der Siliciumdioxid un Silicum enthält mit einer für Siliciumdioxid höheren Ätzrate als für Silicium, das die folgenden Verfahrensschritte umfaßt:

— Einbringen des Gegenstandes in die Plasmaätzkammer;

— Einführen eines gesättigten Halogenkohlenwasserstoffgases in die Kammer mit einstellbarer Durchflußgeschwindigkeit;

— Einführen eines weiteren Gases in die Kammer mit einstellbarer Durchflußgeschwindigkeit, wobei durch letzteres das Halogen/Kohlenstoffverhältnis der Gasmischung herabgesetzt wird;

— Einstellen der relativen Durchflußgeschwindigkeiten beider Gase, wodurch ein gewünschtes Siliciumdioxid/Silicium-Ätzratenverhältnis erhalten wird und

— Ausbilden eines Plasmeas in dem Gas zum Ätzen des Gegenstandes,

dadurch gekennzeichnet,
daß das weitere Gas ein ungesättigter Halogenkohlenwasserstoff ist.

2. Verfahren nach Anspruch 1, dadurch gekennzeichnet, daß der ungesättigte Halogenkohlenwasserstoff $C_3F_6$ ist.

3. Verfahren nach Anspruch 1, dadurch gekennzeichnet, daß der ungesättigte Halogenkohlenwasserstoff $C_2F_4$ ist.

4. Verfahren nach Anspruch 1, dadurch gekennzeichnet, daß die Gasmischung $C_3F_6$ und $CF_4$ enthält.

5. Verfahren nach Anspruch 1, dadurch gekennzeichnet, daß sowohl der ungesättigte wie auch der gesättigte Halogenkohlenwasserstoff Fluor enthält und das Halogen/Kohlenstoffverhältnis der Gasmischung zwischen 2 und 3 liegt.